(19) **Europäisches Patentamt**

**European Patent Office**

**Office européen des brevets**

(11) **EP 1 098 507 A2**

(12) **EUROPEAN PATENT APPLICATION**

(43) Date of publication:
**09.05.2001 Bulletin 2001/19**

(51) Int. Cl.[7]: **H04N 1/40**

(21) Application number: **00123928.4**

(22) Date of filing: **03.11.2000**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **04.11.1999 JP 31337299**

(71) Applicant:
**NuCore Technology Inc.**
**Santa Clara, CA 95051 (US)**

(72) Inventor: **Sasai, Toshihiro**
**Kyoto, 611-0021 (JP)**

(74) Representative:
**Haft, Uwe Michael, Dipl.-Phys.**
**Patentanwälte**
**Haft, von Puttkamer**
**Berngruber, Czybulka**
**Franziskanerstrasse 38**
**81669 München (DE)**

(54) **Image processing apparatus**

(57) An image processing apparatus for outputting desired output data obtained by looking up a look-up table on the basis of input data which represents each pixel value of an input image and has an M (M is an integer of not less than 2) bit width, and converting the input data includes an input compression unit and look-up table. The input compression unit divides the input value range of the input data into a plurality of input sections having individual compression ratios, and outputs compressed data compressed at the compression ratio of an input section to which the input data belongs. The look-up table stores in advance desired output data obtained by converting original input data for all obtained compressed data, and outputs, as desired data, output data corresponding to the compressed data output from the input compression unit. The compression ratios of the respective input sections are assigned to logarithmically increase in accordance with the values of input data belonging to the respective input sections.

FIG. 1

EP 1 098 507 A2

## Description

Background of the Invention

The present invention relates to an image processing apparatus and, more particularly, to an image processing apparatus for converting pixel data with a nonlinear input/output characteristic.

In general, current digital image processing apparatuses widely adopt look-up table (to be referred to as an LUT hereinafter) type conversion processing using LUTs in converting image data with a predetermined input/output characteristic. According to the LUT method, input data is used as an address, and a value read out from the address is output. LUT type conversion processing is effective for nonlinear input/output conversion like gamma correction, and when input data cannot be easily replaced by functional calculation or the processing speed must be high to some extent.

However, when an LUT is arranged for each color signal of an input image, or the number of bits of necessary input/output data is large, the size of the LUT greatly increases.

To prevent this, LUT type conversion processing often uses a method in which an input value obtained by rounding down predetermined lower bits, and a value larger by one (or smaller by one) are input to obtain two output values from an LUT, and the two output values are interpolated based on data made up of the rounded lower bits, thereby attaining an output value corresponding to the original input value.

There is also proposed a method of dividing input data into sections to decrease the number of inputs, and calculating an input value using the coefficient of a predetermined function or the like instead of interpolating an output, thereby attaining an output corresponding to the original input value (e.g., Japanese Patent Laid-Open No. 10-320524).

In the former method, i.e., when an output value is attained by inputting upper bits and interpolating two output values obtained from an LUT, two values must be read out from the LUT, and the read time is doubled. Particularly when pipeline processing is done for high-speed image processing, the LUT read time poses a serious problem. When many lower bits are rounded down in order to decrease the number of inputs to the LUT, an error from a desired characteristic increases.

In the latter method, i.e., when coefficients are output to use different coefficients for respective sections, decreasing the order of a function leads to a result (precision) not so different from the result of linear interpolation described above. From this, an input value is compared with unequal values regardless of rounding lower bits, and the input value is assigned any one of a plurality of sections to interpolate the sections by a low-order function, or the order of the function is increased to ensure the precision. In any case, the circuit scale increases, or the processing time increases. Especially with the use of a high-order function, the calculation time increases in a series manner with an increase in order.

When the signal intensity is to be adjusted for each color before an input from an image sensing element or the like undergoes various signal processes, an LUT must be prepared for each color, and the size of the LUT must be more efficiently reduced.

Summary of the Invention

The present invention has been made to overcome the conventional drawbacks, and has as its object to provide an image processing apparatus capable of minimizing the size of an LUT, performing processing at a high speed, and obtaining a smooth input/output characteristic in image processing using the LUT in order to attain a nonlinear input/output characteristic.

To achieve the above object, according to the present invention, there is provided an image processing apparatus for outputting desired output data obtained by looking up a look-up table on the basis of input data which represents each pixel value of an input image and has an M (M is an integer of not less than 2) bit width, and converting the input data, comprising an input compression unit for dividing an input value range of the input data into a plurality of input sections having individual compression ratios, and outputting compressed data compressed at a compression ratio of an input section to which the input data belongs, and a look-up table for storing in advance desired output data obtained by converting original input data for all obtained compressed data, and outputting, as desired data, output data corresponding to the compressed data output from the input compression unit, wherein the compression ratios of the respective input sections are assigned to logarithmically increase in accordance with values of input data belonging to the respective input sections.

Brief Description of the Drawings

Fig. 1 is a block diagram showing an image processing apparatus according to an embodiment of the present invention;

Fig. 2 is a table showing an example of compression processing performed in an input compression unit;

Fig. 3 is a view showing a compression processing method in Fig. 2;

Fig. 4 is a view showing bit manipulation of compression processing;

Fig. 5 is a block diagram showing an arrangement of an input compression unit according to the first embodiment;

Fig. 6 is a block diagram showing an arrangement of an offset calculation unit;

Fig. 7 is a block diagram showing an arrangement of an LUT unit;

Fig. 8 is a block diagram showing an arrangement of an interpolation unit;

Fig. 9 is a block diagram showing an arrangement of an input compression unit according to the second embodiment; and

Fig. 10 is a graph showing processing operation of a bit inversion unit.

Description of the Preferred Embodiments

The present invention will be described below with reference to the accompanying drawings.

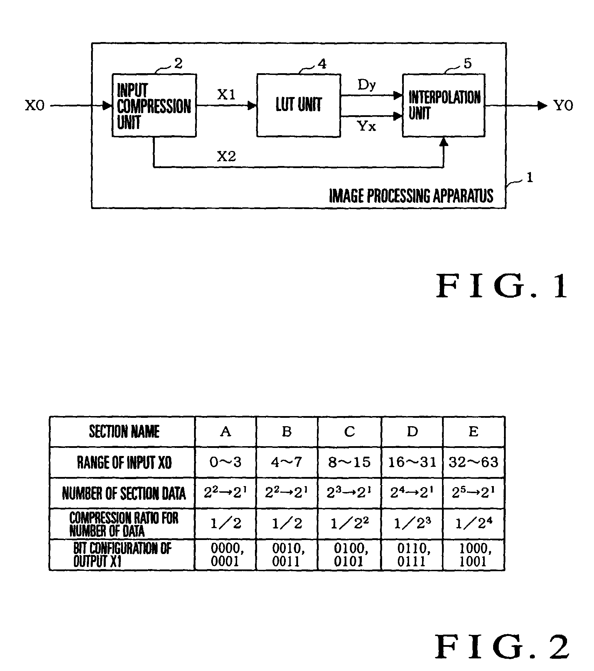

Fig. 1 shows an image processing apparatus according to an embodiment of the present invention. In an image processing apparatus 1, reference numeral 2 denotes an input compression unit for compressing input data X0 representing each pixel value of an input image and outputting compressed data X1; 4, a look up table (to be referred to as an LUT hereinafter) unit for looking up an LUT and outputting output data Yx corresponding to the compressed data X1; and 5, an interpolation unit for interpolating the output data Yx using interpolation data X2 from the input compression unit 2 and relational data Dy from the LUT unit 4, and outputting desired output data Y0.

Fig. 2 shows an example of compression processing performed in the input compression unit. The input compression unit 2 compresses the input data X0 on the basis of logarithmic transformation, e.g., a series of the power of 2, thus generating the compressed data X1. In compressing the input data X0 by logarithmic transformation, the compressed data X1 can be obtained by logarithmic transformation processing, which results in a large circuit scale and low processing speed. In the present invention, a possible input value range (corresponding to the amplitude of a pixel value) of the input data X0 is divided into a plurality of input sections, and the input data X0 is compressed at an individual compression ratio assigned to each input section. In particular, the compression ratios of respective input sections except for input section A where the value of input data is smallest are assigned to be twice (1/2 times) between adjacent sections. The input data X0 belonging to each input section is compressed at the compression ratio of the section. This obviates the need for a special arrangement for logarithmic calculation processing, and can realize compression processing by only bit manipulation of the input data X0.

The compression ratio is determined by the ratio of the number of input data X0 belonging to respective input sections to the number of compressed data X1 after compressing the input data X0. In the present invention, input sections are defined to set the number of input data X0 to be twice (1/2 times) between adjacent sections except for an input section where the value of input data is smallest. At the same time, the number of compressed data X1 is equal between all the input sections. Accordingly, compression ratios taking values of the series of the power of 2 can be assigned respective input sections except for the input section where the value of input data is smallest.

Fig. 2 shows, for each input section when the input data X0 is made up of 6 bits (M = 6), an input data value belonging to the section, the compression ratio, and a compressed data value after the input data X0 is compressed. For example, all input data X0 having a value "001xxx", i.e., "$2^3$" to "$2^4$-1" belong to input section C. Input data in this range is converted into either of two compressed data "0100" and "0101". In input section C, $2^3$ input data are compressed into two data, and the compression ratio is $1/2^2$.

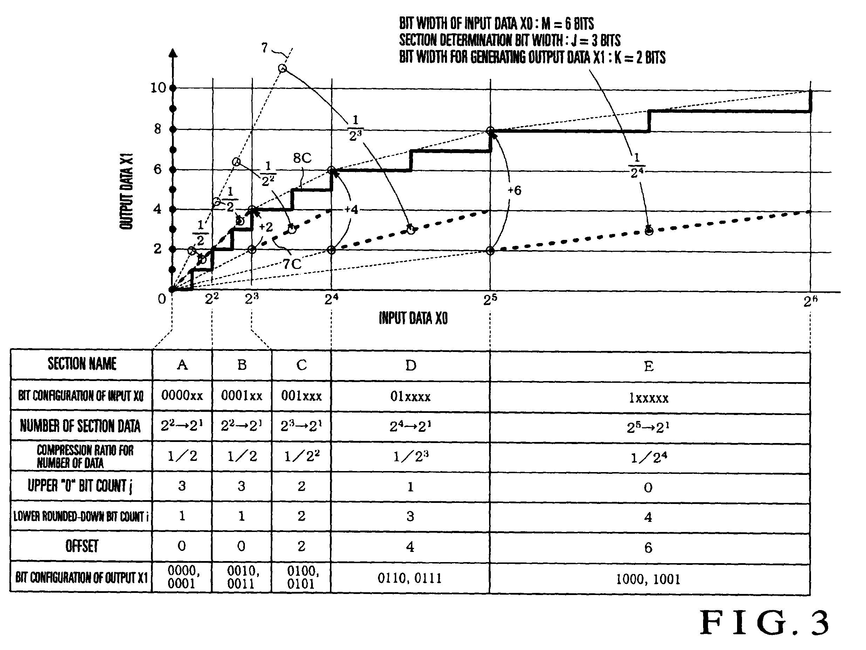

Fig. 3 shows the compression processing method in Fig. 2. In input section C, the compression ratio is $1/2^2$, and a compression conversion function 7C at this time can be regarded as a function prepared by rotating to $1/2^2$ the slope of a reference function 7 along which input data X0 and compressed data X1 correspond to each other at 1 : 1. Compressed data X1 which input section C takes is "0100" or "0101", and thus the compression conversion function 7C must be shifted. This shift will be called an offset. Note that both the input data X0 and compressed data X1 take discrete values, i.e., digital values, and are actually expressed by a compression conversion function 8C which changes stepwise.

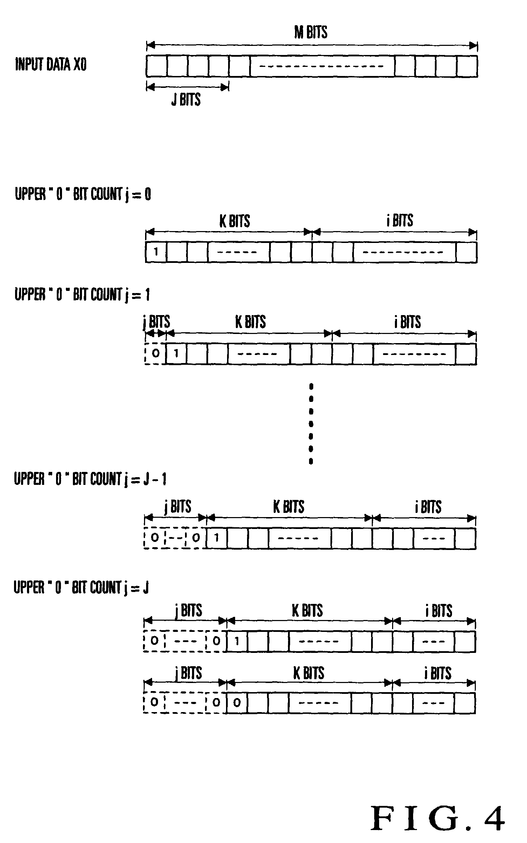

As a method of generalizing this compression processing, the present invention executes bit manipulation as shown in Fig. 4. In input data X0 of M (M is an integer of 2 or more) bits, J (J is a positive integer smaller than M) bits from the most significant bit are used as section determination data 1A. An input section to which the input data X0 belongs is determined based on the number of successive determination bit values "0" from the most significant bit of the section determination data 1A, i.e., a determination bit count j. As a result, input sections having individual compression ratios of the series of the power of 2 are set in the input value range of the input data X0.

Bits corresponding to the determination bit count j from the most significant bit are eliminated from the input data X0, and K (K is a positive integer smaller than M) bits from the most significant bit out of the residual bits (M-j bits) are extracted as output generation data. An offset value corresponding to the input section is added to the output generation data to obtain compressed data X1. As is apparent from the compression processing method shown in Fig. 3, an offset value corresponding to each input section is calculated by $2^{K-1} \cdot (J-j+2)$ for $j \neq J$, and is 0 for $j = J$. A circuit arrangement for implementing this compression processing will be explained.

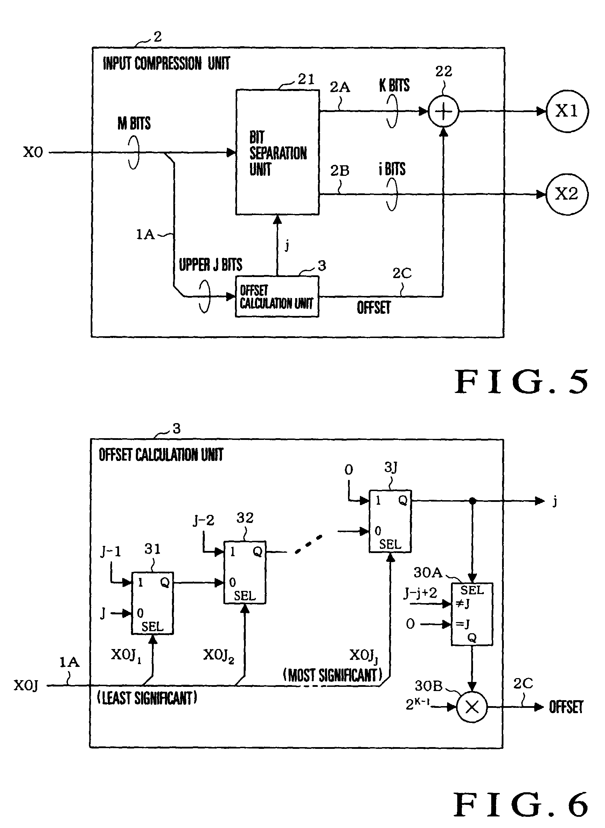

Fig. 5 shows an arrangement of the input compression unit according to the first embodiment of the present invention. Fig. 6 shows an arrangement of an offset calculation unit. In the input compression unit 2, M-bit input data X0 is input to a bit separation unit 21, and section determination data 1A of J bits from the most significant bit is input to an offset calculation unit 3.

The offset calculation unit 3 includes selectors 31 to 3J in correspondence with the least significant bit $X0J_1$ to most significant bit $X0J_J$ of the J bits constituting the section determination data 1A. The selectors 31 to 3J respectively receive values "J-1" to "0" on their input 1 side, and are connected on their input 0 side to outputs Q of preceding selectors. The input 0 side of the selector 31 receives a value "J".

Of the bits of the section determination data 1A, the input 1 side is selected in a selector corresponding to a bit which changes to "1" first from the most significant bit $X0J_J$. The selected bit passes through selectors positioned on the output stage, and output as the determination bit count j. The determination bit count j is input to a selector 30A where j is compared with J. For $j = J$, 0 is selected and output. For $j \neq J$, $J-j+2$ is selected and output. Either output is input to a multiplier 30B where the output is multiplied by $2^{K-1}$. The multiplier 30B outputs 0 for $j = J$ and $2^{K-1} \cdot (J-j+2)$ for $j \neq J$ as an offset value 2C of an input section to which the input data X0 belongs.

The bit separation unit 21 eliminates, from the M-bit input data X0, bits corresponding to the determination bit count j from the most significant bit on the basis of the determination bit count j from the offset calculation unit 3. The bit separation unit 21 separates K bits from the most significant bit, from the residual bits (M-j bits), outputs the K bits as output generation data 2A, and outputs i ( i = M-j-K ) bits of the residual lower bits as interpolation data 2B. An adder 22 adds the output generation data 2A and the offset value 2C from the offset calculation unit 3, and outputs the sum as compressed data X1 corresponding to the input data X0.

In the above description, i changes depending on j. In constituting an apparatus, the bit separation unit 21 may shift the input data X0 to an upper side by j bits, pad 0 from the least significant bit, then separate K bits from the most significant bit as the output generation data 2A, and separate the residual lower (M-K) bits as interpolation data having the fixed number of bits.

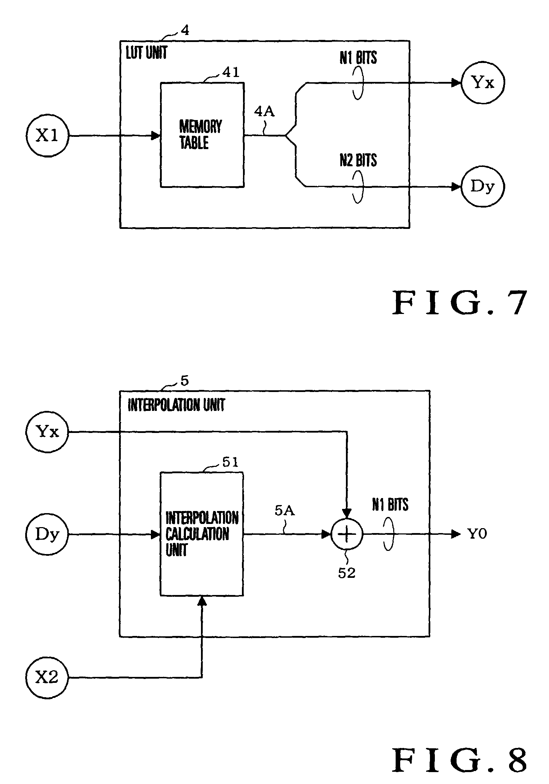

In this manner, the compressed data X1 obtained by the input compression unit 2 is input to the LUT unit 4. Fig. 7 shows an arrangement of the LUT unit. Reference numeral 41 denotes a memory table (ROM or RAM) for storing output data Yx and relational data Dy in correspondence with all possible values of the compressed data X1. The output data Yx and relational data Dy are bit-linked and stored as one data in the memory table 41. The output data Yx stores a desired output data value obtained by converting input data representing the minimum value among respective input data compressed to the same compressed data X1 by the input compression unit 2.

The relational data Dy is a data value representing the relationship between the output data Yx, and output data Yx' corresponding to compressed data X1' succeeding (or preceding) the compressed data X1. An example of the relational data Dy is a difference Yx'-Yx between the two output data values. The relational data Dy may be data representing a gradient from Yx to Yx'. The relational data Dy suffices to be data which has a smaller number of bits or enables high-speed calculation, and allows calculating the output data Yx' from the output data Yx and relational data Dy. In this case, the output data Yx is expressed by N1 bits, and relational data Dy is by N2 bits.

The interpolation unit 5 uses the output data Yx, the relational data Dy, and the data X2 from the input compression unit 2 to interpolate the output data Yx, thereby generating desired output data Y0. Fig. 8 shows an arrangement of the interpolation unit. Reference numeral 51 denotes an interpolation calculation unit for calculating output difference data 5A from the relational data Dy and data X2; and 52, an adder for adding the output difference data 5A to the output data Yx to calculate the desired output data Y0. An example of the arithmetic expression of the output difference data 5A in the interpolation calculation unit 51 is $Dy \cdot X2/2^i$. The arithmetic expression suffices to slightly adjust the relational data Dy using the interpolation data X2 made up of lower bits of the output generation data 2A.

Assuming that the output data Y0 is attained by interpolation using the output data Yx and relational data Dy, i > 0 must hold.

The compression ratio in the input compression unit 2 and the compression ratio for the size (total number of bits) of the whole LUT are as follows:

$$\text{Compression Ratio of Input Data} = \frac{2^{K-1} \cdot (J+2)}{2^M} \tag{1}$$

$$= 2^{K-M-1} \cdot (J+2)$$

$$\text{Compression Ratio of Whole LUT} = \frac{(N1+N2)}{N1} \cdot \text{Compression Ratio of Input Data} \tag{2}$$

$$= \frac{(N1+N2) \cdot 2^{K-M-1} \cdot (J+2)}{N1}$$

In practice, for, e.g., K = 7, J = 3, M = 12, N1 = 10, and N2 = 2, the compression ratio of the whole LUT is 6/128 ≒ 0.0469, and the total number of bits can be decreased to about 1/20. For N2 = 5, the compression ratio is 15/128 ≒ 0.117, and the total number of bits of the LUT can be decreased to 1/8 or less. When equal sections are set by rounding down lower bits, N2 cannot be set small. In the present invention, N2 can be set small to contribute to compression of the total number of bits because an input value is not greatly compressed in a section exhibiting large changes in output value with respect to the input value, but an input value is greatly compressed in a section exhibiting small changes in output value with respect to the input value.

In the present invention, compression ratios are logarithmically, individually assigned to respective input sections, compressed data X1 compressed at the compression ratio of an input section to which input data X0 belongs is calculated by the input compression unit 2, and desired output data obtained by looking up the memory table (LUT) 41 of the LUT unit 4 for the compressed data X1 and converting the original input data X0 is output. Hence, a different compression ratio can be used in accordance with the value of the input data X0. Compared to the prior art, the size of the LUT can be greatly reduced, and the LUT can be efficiently compressed with hardly decreasing the conversion precision.

In particular, the compression ratios of respective input sections are assigned to logarithmically increase as the values of input data in the input sections increase. In gamma conversion in which the output greatly changes for a small input value and hardly changes for a large input value, the LUT can be compressed with hardly degrading the image quality. Actual gamma correction or the like must be individually performed for respective color signals (R, G, and B) constituting an input image. By parallel-arranging at least the input compression units 2 and LUT units 4 of the present invention for respective color signals, the color signals can be simultaneously converted in parallel with each other with individual input/output characteristics for the respective color signals. Pipeline processing can be done for an input image in real time, and image processing can be done at a very high speed.

The compression ratios of the respective input sections are assigned to increase for each power of 2 in accordance with the values of input data X0 belonging to these input sections. With this setting, input data X0 can be compressed in all the input sections having different compression ratios by binary bit operation without performing any complicated logarithmic calculation, and the circuit arrangement of the input compression unit 2 can be greatly simplified. As a method of setting the compression ratio, the input value range of input data X0 is divided with a range width corresponding to the number of input data which increases by power of 2 in accordance with the value of input data X0 belonging to each input section, and a possible number of compressed data in each input section is set equal between all the input sections. Compression ratios which increase for each power of 2 can be easily assigned respective input sections.

The compression ratio of each input section is constant within the input section. This obviates the need to individually change calculation processing of compressed data X1 in accordance with the value of input data X0. The circuit arrangement of the input compression unit 2 can be greatly simplified, and high-speed processing can be realized.

As a detailed arrangement format of each input section, each input section is arranged in the input value range of the input data X0 on the basis of the determination bit count j by which predetermined determination bit values are successive from the most significant bit of the input data X0 within the section determination data 1A made up of bits corresponding to the determination bit count J from the most significant bit of the input data X0. Thus, each input section and input data X0 can be associated with each other by simple bit operation.

As a detailed circuit arrangement of the input compression unit 2, the input compression unit 2 comprises the offset calculation unit 3 for calculating the offset value 2C of an input section to which input data X0 belongs, and the bit separation unit 21 for separating, as the output generation data 2A, K bits from the most significant bit out of residual bits after bits corresponding to the determination bit count j are eliminated from the input data X0. The output generation data 2A and offset value 2C are added by the adder 22 to calculate compressed data X1. The offset calculation unit 3 calculates the offset value 2C by $2^{K-1} \cdot (J-j+2)$ (or 0 for j = J ). Accordingly, the circuit arrangement of the input compression unit 2 can be greatly simplified, and high-speed processing can be realized.

The LUT unit 4 parallel-outputs output data Yx, and relational data Dy representing the relationship between the output data Yx and output data Yx' corresponding to compressed data X1' preceding or succeeding input compressed data X1. Using the output data Yx, the relational data Dy, and interpolation data X2 made up of lower bits out of the residual bits except for the output generation data 2A, the interpolation unit 5 interpolates the output data Yx to output desired output data Y0. Hence, a smooth nonlinear input/output characteristic can be obtained. Two output data need not be read out from the LUT, unlike the prior art, and interpolation processing can be executed at a high speed. This is very effective because the number of LUT look-up operations requiring a long access time can be decreased when the LUT is used in pipeline processing.

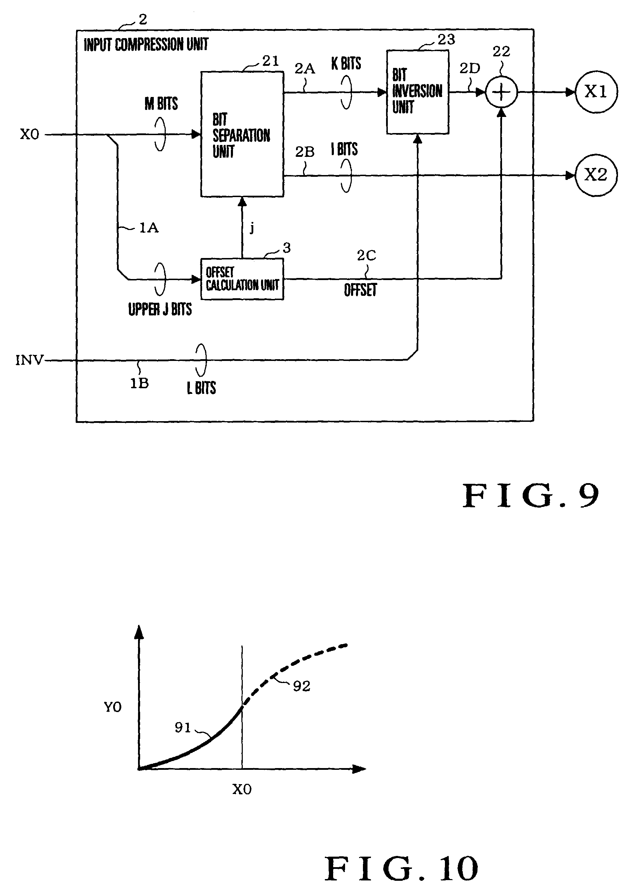

The second embodiment of the present invention will be described with reference to Fig. 9. Fig. 9 shows an arrangement of an input compression unit according to the second embodiment. In the second embodiment, a bit inversion unit 23 is inserted between the bit separation unit 21 and adder 22 of the input compression unit 2 in the first embodiment (see Fig. 5). The bit inversion unit 23 bit-inverts and shifts output generation data 2A from the bit separation unit 21 on the basis of inversion instruction data INV of L bits which changes in correspondence with input data X0. Then, the bit inversion unit 23 outputs inverted data 2D.

Of a desired nonlinear input/output characteristic, sections having similar curves can use the curve of a reference section. For example, to obtain a complicated S-shaped input/output characteristic as shown in Fig. 10, a curve 91 is inverted and shifted to obtain a curve 92. Therefore, the size of the LUT can be efficiently compressed. Although Fig. 10 shows a characteristic for L = 1 bit, the LUT can be efficiently compressed even for a more complicated characteristic by increasing L.

As the inversion instruction data INV, e.g., L bits from the most significant bit of the input data X0 are used. Residual input data after the inversion instruction data INV is eliminated from the input data X0 may be supplied to the bit separation unit 21 and an offset calculation unit 3 to perform the same compression processing as described above. Accordingly, a complicated input/output characteristic which changes in accordance with the size of the input data X0 can be obtained. Parameters, e.g., K, j, and i used in the input compression unit 2 may be switched for each section corresponding to the L value, and the LUT can be more efficiently compressed. With the use of the LUT, the input/output characteristic is not limited to one in which output data Y0 monotonically increases with respect to the input data X0. Even an input/output characteristic in which the output decreases when the input exceeds a certain value can also be generated by a combination of characteristics as shown in Fig. 10.

As has been described above, according to the present invention, compression ratios are logarithmically, individually assigned to respective input sections, compressed data compressed at the compression ratio of an input section to which input data belongs is calculated by an input compression unit, and a look-up table is looked up for the compressed data, thereby attaining desired output data. Compared to the prior art, the size of the LUT can be extensively reduced, and the LUT can be efficiently compressed with hardly decreasing the conversion precision.

In particular, the compression ratios of respective input sections are assigned to logarithmically increase as the values of input data in the input sections increase. In gamma conversion in which the output greatly changes for a small input value and hardly changes for a large input value, the LUT can be compressed with hardly degrading the image quality. Furthermore, the compression ratios of respective input sections are assigned to increase for each power of 2 in accordance with the values of input data belonging to the input sections. Input data can be compressed in all the input sections having different compression ratios by binary bit operation without performing any complicated logarithmic calculation. The circuit arrangement of the input compression unit can be greatly simplified, and high-speed processing can be realized.

**Claims**

1. An image processing apparatus for outputting desired output data obtained by looking up a look-up table on the basis of input data which represents each pixel value of an input image and has an M (M is an integer of not less than 2) bit width, and converting the input data, characterized by comprising:

an input compression unit (2) for dividing an input value range of the input data (X0) into a plurality of input sections having individual compression ratios, and outputting compressed data (X1) compressed at a compression ratio of an input section to which the input data belongs; and
a look-up table (4) for storing in advance desired output data obtained by converting original input data for all obtained compressed data, and outputting, as desired data, output data corresponding to the compressed data output from said input compression unit,
wherein the compression ratios of the respective input sections are assigned to logarithmically increase in accordance with values of input data belonging to the respective input sections.

2. An apparatus according to claim 1, wherein the compression ratios of the respective input sections are assigned to increase for each power of 2 in accordance with the values of the input data belonging to input sections except for an input section where the value of input data is smallest.

3. An apparatus according to claim 1, wherein the respective input sections are set by dividing the input value range of the input data by a range width corresponding to the number of input data which increases for each power of 2 in accordance with the values of the input data belonging to the respective input sections, and a possible number of compressed data in each input section is set equal between all the input sections.

4. An apparatus according to claim 1, wherein the compression ratio of each input section is constant within the input section.

5. An apparatus according to claim 1, wherein each input section is arranged in the input value range of the input data on the basis of a determination bit count j (j is an integer of 0 to J) by which predetermined determination bit values are successive from a most significant bit within section determination data made up of bits corresponding to a determination bit count J (J is a positive integer smaller than M) from the most significant bit of the input data.

6. An apparatus according to claim 5, wherein said input compression unit (2) comprises an offset calculation unit (3) for calculating a predetermined offset value in correspondence with an input section of the input data, a bit separation unit (21) for separating, as output generation data, bits corresponding to a predetermined bit count K (K is a positive integer smaller than M) from the most significant bit out of residual bits after bits corresponding to the determination bit count j are eliminated from the input data, and an adder (22) for adding the output generation data from said bit separation unit to the offset value from said offset calculation unit.

7. An apparatus according to claim 6, wherein said offset calculation unit (3) outputs, as the offset value, 0 for $j = J$ and a calculation result of $2^{K-1} \cdot (J-j+2)$ for $j \neq J$.

8. An apparatus according to claim 5, wherein

said look-up table (4) parallel-outputs output data for the input compressed data, and relational data representing a relationship between the output data and output data corresponding to compressed data preceding or succeeding the compressed data, and
said apparatus further comprises an interpolation unit (5) for outputting data obtained by interpolating the output data using the output data, the relational data, and data made up of lower bits out of the residual bits except for the output generation data.

9. An apparatus according to claim 6, wherein said input compression unit (2) comprises a bit inversion unit (23) for inverting each bit of output generation data output from a bit separation unit on the basis of inversion instruction data made up of L (L is a positive integer) bits, and outputting the inverted bit to an adder.

10. An apparatus according to claim 9, wherein

the inversion instruction data uses bits corresponding to an inversion section bit count L (L is a positive integer) from the most significant bit of the input data,
said offset calculation unit (3) calculates an offset value from (M-L)-bit residual input data after the inversion section data is eliminated from the input data, and
said bit separation unit (21) separates the output generation data from the residual input data, and outputs the output generation data.

11. An apparatus according to claim 1, further comprising at least input compression units (2) and look-up table units (4) in parallel with each other for respective color signals constituting an input image.

FIG. 1

| SECTION NAME | A | B | C | D | E |
|---|---|---|---|---|---|
| RANGE OF INPUT X0 | 0~3 | 4~7 | 8~15 | 16~31 | 32~63 |
| NUMBER OF SECTION DATA | $2^2 \rightarrow 2^1$ | $2^2 \rightarrow 2^1$ | $2^3 \rightarrow 2^1$ | $2^4 \rightarrow 2^1$ | $2^5 \rightarrow 2^1$ |
| COMPRESSION RATIO FOR NUMBER OF DATA | $1/2$ | $1/2$ | $1/2^2$ | $1/2^3$ | $1/2^4$ |
| BIT CONFIGURATION OF OUTPUT X1 | 0000, 0001 | 0010, 0011 | 0100, 0101 | 0110, 0111 | 1000, 1001 |

FIG. 2

BIT WIDTH OF INPUT DATA X0 : M = 6 BITS
SECTION DETERMINATION BIT WIDTH : J = 3 BITS
BIT WIDTH FOR GENERATING OUTPUT DATA X1 : K = 2 BITS

OUTPUT DATA X1

INPUT DATA X0

| SECTION NAME | A | B | C | D | E |
|---|---|---|---|---|---|
| BIT CONFIGURATION OF INPUT X0 | 0000xx | 0001xx | 001xxx | 01xxxx | 1xxxxx |
| NUMBER OF SECTION DATA | $2^2 \rightarrow 2^1$ | $2^2 \rightarrow 2^1$ | $2^3 \rightarrow 2^1$ | $2^4 \rightarrow 2^1$ | $2^5 \rightarrow 2^1$ |
| COMPRESSION RATIO FOR NUMBER OF DATA | $1/2$ | $1/2$ | $1/2^2$ | $1/2^3$ | $1/2^4$ |
| UPPER "0" BIT COUNT j | 3 | 3 | 2 | 1 | 0 |
| LOWER ROUNDED-DOWN BIT COUNT i | 1 | 1 | 2 | 3 | 4 |
| OFFSET | 0 | 0 | 2 | 4 | 6 |
| BIT CONFIGURATION OF OUTPUT X1 | 0000, 0001 | 0010, 0011 | 0100, 0101 | 0110, 0111 | 1000, 1001 |

FIG. 3

EP 1 098 507 A2

M BITS

INPUT DATA X0

J BITS

UPPER " 0 " BIT COUNT j = 0

K BITS          i BITS

| 1 | | | ------ | | | | ------ | |

UPPER " 0 " BIT COUNT j = 1

j BITS          K BITS          i BITS

| O | 1 | | | ----- | | | | | -------- | |

UPPER " 0 " BIT COUNT j = J - 1

j BITS          K BITS          i BITS

| O | -- | O | 1 | | | ----- | | | | | --- | |

UPPER " 0 " BIT COUNT j = J

j BITS          K BITS          i BITS

| O | --- | O | 1 | | | ----- | | | | --- | |

j BITS          K BITS          i BITS

| O | --- | O | O | | | ----- | | | | --- | |

# FIG. 4

## INPUT COMPRESSION UNIT

```
                                              21        2A      K BITS         22
                                          BIT
              M BITS                      SEPARATION
                                          UNIT                                         X1
X0                                                      2B      i BITS
                                                                                       X2
              1A
                                              j
              UPPER J BITS           3                          2C
                                  OFFSET
                                  CALCULATION UNIT              OFFSET
```

# F I G. 5

## OFFSET CALCULATION UNIT

```
                                                   0      3J
                                               1    Q                        j
                               J-2    32
                            1    Q
                                                   0
               J-1   31                            SEL
                            0                                    30A
            1    Q           SEL                            SEL
                                                   J-j+2    ≠J
J                                                          =J
            0                                      0        Q
            SEL
1A        X0J₁              X0J₂                    X0Jⱼ
X0J                                                (MOST SIGNIFICANT)
          (LEAST SIGNIFICANT)                               30B          2C
                                                           2^(K-1)           OFFSET
```

# F I G. 6

LUT UNIT 4

41
MEMORY
TABLE

X1

4A

N1 BITS
Yx

N2 BITS
Dy

FIG. 7

INTERPOLATION UNIT 5

Yx

51
INTERPOLATION
CALCULATION
UNIT

Dy

5A

52

N1 BITS
YO

X2

FIG. 8

F I G. 9

F I G. 10